(19) Europäisches Patentamt
European Patent Office
Office européen des brevets

(11) EP 0 619 337 B1

(12) **EUROPÄISCHE PATENTSCHRIFT**

(45) Veröffentlichungstag und Bekanntmachung des Hinweises auf die Patenterteilung:
**05.02.1997 Patentblatt 1997/06**

(51) Int Cl.[6]: **C08G 73/00**, G03F 7/039

(21) Anmeldenummer: **94105237.5**

(22) Anmeldetag: **05.04.1994**

(54) **Photolabile Polymere mit Triazen- oder/und Pentazadien-Bausteinen**

Photolabile Polymer with triazene and/or pentazadiene units

Polymère photolabile comportant des unités triazène et/ou pentazadiène

(84) Benannte Vertragsstaaten:
**DE ES FR GB IT**

(30) Priorität: **06.04.1993 DE 4311253**

(43) Veröffentlichungstag der Anmeldung:
**12.10.1994 Patentblatt 1994/41**

(73) Patentinhaber: **BOEHRINGER MANNHEIM GMBH**
**D-68305 Mannheim-Waldhof (DE)**

(72) Erfinder:
- **Stebani, Jürgen, Dr.**
  **D-47800 Krefeld (DE)**
- **Nuyken, Oskar, Prof.**
  **D-81927 München (DE)**
- **Sluka, Peter, Dr.**
  **D-82362 Weilheim (DE)**
- **Finckh, Peter, Dr.**
  **D-86911 Diessen (DE)**

(74) Vertreter: **Huber, Bernhard, Dipl.-Chem. et al**
**Patentanwälte**
**H. Weickmann, Dr. K. Fincke**
**F.A. Weickmann, B. Huber**
**Dr. H. Liska, Dr. J. Prechtel, Dr. B. Böhm**
**Postfach 86 08 20**
**81635 München (DE)**

(56) Entgegenhaltungen:
- **MAKROMOLEKULARE CHEMIE, RAPID COMMUNICATIONS Bd. 14 , 1993 , BASEL CH Seiten 365 - 369 STEBANI ET AL. 'Synthesis and characterization of a novel photosensitive triazene polymer'**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 619 337 B1

Printed by Jouve, 75001 PARIS (FR)

## Beschreibung

Die vorliegende Erfindung betrifft die Verwendung von Triazen- oder Pentazadien-Polymeren als Photoresiste, insbesondere als positive Photoresiste. Die Erfindung betrifft weiterhin ein Verfahren zur Herstellung von neuen Triazen- oder Pentazadien-Polymeren sowie die durch dieses Verfahren erhältlichen Produkte.

Aus der Produktionstechnik für elektronische Bauteile sind Photoresiste bekannt. Darunter versteht man im weiteren Sinne strahlungsempfindliche, im speziellen Falle lichtempfindliche Materialien, die ihre Löslichkeit bei der Bestrahlung verändern. Je nachdem, ob die Löslichkeit des Materials bei der Strahlungseinwirkung erhöht oder erniedrigt wird, wird von einem positiven bzw. negativen Photoresist gesprochen. Diese Änderung der Löslichkeit aufgrund von photochemischen oder strahlenchemischen Reaktionen erfolgt im allgemeinen durch eine Verkleinerung oder Vergrößerung des Molekulargewichts, einer Änderung der Polarität oder der molekularen Wechselwirkungen der Resistbestandteile.

Ein kurzer Überblick über die Funktion und die chemische Struktur von heute verwendeten kommerziellen Photoresisten ist bei Steppan et al., Angew. Chem. 94 (1982), 471-564 und Henkes, Die Umschau 1985, Heft 2 wiedergegeben. Als positive Photoresiste sind dort beispielsweise Diazonaphthochinon-, O-Diazochinon- und O-Nitrobenzylester-Systeme beschrieben. Diese Photoresiste zeichnen sich dadurch aus, daß nach Belichtung der Masse Säurefunktionen entstehen. Auf diese Weise werden die Harzbestandteile zwar wasserlöslich, jedoch nur bei extremen pH-Werten, wodurch die Anwendung dieser Systeme im Zusammenhang mit biochemischen Reagenzien nur sehr eingeschränkt möglich ist.

Shirai et al., Macromol.Chem. 190 (1989), 2099-2107 beschreiben die Synthese von in Wasser bei neutralem pH entwicklungsfähigen positiven Photoresisten, bei denen es sich um Polymere mit Iminooxysulfonylgruppen handelt. Im Anschluß an die Entwicklung dieser Photoresiste ist jedoch eine alkalische Waschung erforderlich, wodurch eine mögliche Anwendung auf dem Gebiet der Biochemie nur sehr beschränkt möglich ist.

Von Ito und Willson, Polymer Eng.Sci. 23 (1983), 1012-1017 ist ein trocken entwickelbarer positiver Photoresist beschrieben, der aus Poly(phthalaldehyd) und einem kationischen Photoinitiator, wie etwa einem Diaryljodonium- oder Triarylsulfonium-Metallhalogenid formuliert wird. Ein Nachteil dieses Photoresists liegt jedoch u.a. in seiner geringen Lichtempfindlichkeit.

Die bisher in der Literatur beschriebenen Triazene oder Pentazadiene beschränken sich meist auf niedermolekulare, monofunktionelle Verbindungen, d.h. Verbindungen mit einem oder zwei dieser Bausteine. Ausnahmen bilden hierbei zwei bisher beschriebene Triazenpolymere (Behringer und Kohl, Chem.Ber. 89 (1956), 2648-2653, Hauser, J. Org.Chem. 29 (1964), 3449 und US-A-3,431,251):

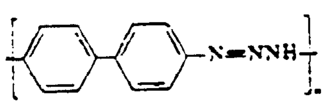

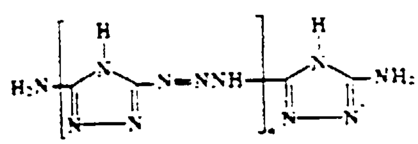

Die Verknüpfungseinheit dieser Polymere wird durch eine sogenannte 1,3-Diaryl-triazen-Einheit gebildet, bei der zwei identische aromatische Verbindungen ein über Triazen-Einheiten verknüpftes Polymer aufbauen. Zur Herstellung derartiger Polymere stehen zwei präparative Varianten zur Verfügung:

1. Eine Bis(aminoaryl)-Verbindung "A-A" wird nur auf einer Seite unter Bildung eines "A-B"-Bausteines diazotiert und polymerisiert. Das enstehende Polymer besitzt dann die theoretische Sequenzfolge $(A\text{-}B)_n$.

2. Eine zweifache Diazotierung einer Bis(aminoaryl)-Verbindung "A-A" ergibt einen "B-B"-Baustein. Eine Reaktion dieses Moleküls mit einer äquimolaren Menge an Ausgangsverbindung "A-A" ergibt ein Polymer mit der theoretischen Sequenzfolge $(A\text{-}AB\text{-}B)_n$.

Nach den oben beschriebenen Polymerisationsreaktionen zur Bildung von Triazen-Polymeren sind ausschließlich Poly(bis-aryltriazene) erhältlich. Eine Herstellung von Pentazadien-Polymeren ist nach dieser Methode nicht möglich.

Eine Verwendung von Triazen-Polymeren als Photoresist war bisher ebenfalls nicht bekannt.

Eine Aufgabe der vorliegenden Erfindung bestand darin, neue Photoresiste bereitzustellen, die sich insbesondere bei der Anwendung bei biochemischen Verfahren eignen.

Diese Aufgabe wird erfindungsgemäß mit der Verwendung von Triazen- oder/und Pentazadien-Polymeren als Photoresiste, insbesondere als positive Photoresiste gelöst. Der Begriff "Triazen- oder/und Pentazadien-Polymer" gemäß vorliegender Erfindung umfaßt Triazen-, Pentazadien- und Triazen-Pentazadien-Mischpolymere. Der Begriff umfaßt solche Polymere, die durch Triazen- oder/und Pentazadiengruppen verknüpfte Bausteine aufweisen, aber auch solche Polymere, die durch andere Bindungen (z.B. Peptidbindungen, Etherbindungen) verknüpfte Bausteine aufweisen und bei denen sich Triazen- oder/und Pentazadienfunktionen an den Enden oder/und an Seitengruppen des Polymers befinden.

Ein überraschender Vorteil der Verwendung von Triazen- und Pentazadien-Polymeren als Photoresistmaterialien beruht auf der hohen Geschwindigkeit der Photolysereaktion bei diesen Substanzen. Je nach Ausgangsverbindung für die Synthese lassen sich Polymere herstellen, die entweder als positive Photoresiste (belichtete Stellen lösen sich besser im Entwickler als unbelichtete Stellen) oder auch als negative Photoresiste (belichtete Stellen lösen sich im Entwickler schlechter als unbelichtete Stellen) verwendet werden können.

Die Klasse der Triazen-Polymere zeichnet sich dabei durch eine hohe Thermolysebeständigkeit aus, die Zersetzungstemperaturen der Polymeren reichen im allgemeinen bis zu 250°C. Pentazadien-Polymere sind dagegen im allgemeinen nur bis etwa 100°C stabil, sie weisen aber eine erheblich höhere Photolysegeschwindigkeit auf.

Ein besonderer Vorteil bei der Verwendung von Triazen- und Pentazadien-Polymeren als positive Photoresiste liegt darin, daß die nach einer Belichtung entstehenden Polymerfragmente auch bei neutralen pH-Werten wasserlöslich sind, wodurch sich eine hervorragende Anwendung im Gebiet der Biochemie und der dort verwendeten, stark pH-empfindlichen biologischen Reagenzien ergibt.

Triazen- und Pentazadien-Polymere können somit beispielsweise als photolabile Schutzschichten zur Abdeckung biochemischer Reagenzien verwendet werden. Eine derartige Abdeckung ist beispielsweise bei einem Verfahren zur Bestimmung eines Analyten erforderlich, bei dem mehrere Reagenzien zu unterschiedlichen Zeiten mit der Probe in Kontakt gebracht werden müssen, ohne daß eine nachträgliche Zudosierung eines Reagenz erforderlich ist. Ein solches Verfahren könnte beispielsweise derart durchgeführt werden, daß ein erstes Reagenz sich in dem Reaktionsgefäß in einer bei Zugabe von Probenflüssigkeit sofort löslicher Form befindet, während ein zweites Reagenz und gegebenenfalls weitere Reagenzien von verzögert löslichen Schutzschichten umschlossen sind, die einen vorzeitigen Kontakt der darunter befindlichen Reagenzien mit der Probenflüssigkeit verhindert. Bei Verwendung von photolabilen Schutzschichten aus Triazen- oder Pentazadien-Polymeren ist es möglich, die zeit der Reaktion des ersten Reagenz mit der Probenflüssigkeit auf einfache Weise in weiten Grenzen dadurch zu variieren, daß zum gewünschten Startzeitpunkt der zweiten Teilreaktion die Schutzschicht lediglich mit Licht einer geeigneten Wellenlänge bestrahlt werden muß. Die dadurch bedingte Zerstörung der Schutzschicht hat einen sofortigen Kontakt der Probenflüssigkeit mit einem sich unter der Schutzschicht befindlichen Reagenz zur Folge. Gegebenenfalls kann auch eine weitere geschlossene Zwischenschicht, die kein spezifisches Reagenz enthält, zwischen der das zweite Reagenz enthaltenden Grundschicht auf dem Reaktionsgefäß und der Schutzschicht aus dem positiven Photoresist angebracht werden.

Ein besonders bevorzugter Aspekt der Erfindung ist daher die Verwendung von Triazen- oder/und Pentazadien-Polymeren als positive Photoresiste in einem Verfahren zur Bestimmung eines Analyten in einer Probenflüssigkeit durch eine in mehreren zeitlich voneinander getrennten Stufen ablaufenden Reaktion. Ein solches Verfahren ist vorzugsweise dadurch gekennzeichnet, daß man die den Analyten enthaltende Probeflüssigkeit in ein Reaktionsgefäß gibt, das mindestens zwei zur Durchführung der Bestimmungsreaktion erforderliche Reagenzien in einer leicht in der Probeflüssigkeit löslichen und räumlich voneinander getrennten Form enthält, wobei ein für die erste Reaktionsstufe vorgesehenes erstes Reagenz in einer ohne Verzögerung in der Probeflüssigkeit löslichen Form ist, während ein für die zweite Reaktionsstufe vorgesehenes zweites Reagenz und gegebenenfalls weitere Reagenzien voneinander und von dem ersten Reagenz getrennt sind und durch Schutzschichten vor einem sofortigen Kontakt mit der Probeflüssigkeit geschützt sind, wobei die Schutzschichten derart ausgestaltet sind, daß sie einen zeitlich verzögerten Kontakt zwischen der den Analyten enthaltenden Probeflüssigkeit und dem sich unter der jeweiligen Schutzschicht befindlichen Reagenz ermöglichen, so daß eine Reaktion des Analyten mit den Reagenzien in mehreren zeitlich voneinander getrennten Stufen stattfinden kann, und daß man den Analyten nach Ablauf der Reaktion in homogener flüssiger Phase bestimmt.

Ein weiterer Gegenstand der vorliegenden Erfindung ist ein Verfahren zur Herstellung neuer Triazen- oder Pentazadien-Polymere, welches dadurch gekennzeichnet ist, daß man eine bifunktionelle aromatische oder heteroaromatische Aminoverbindung durch Diazotierung zu einem entsprechenden Bis-Diazoniumsalz umsetzt und dieses anschließend mit einer Aminogruppen-haltigen Verbindung in einer Polykondensationsreaktion zur Erzeugung eines Polymers umsetzt, wobei man als Aminogruppen-haltige Verbindung

(a) ein bifunktionelles primäres oder sekundäres Amin der allgemeinen Formel (I)

$$R^1 - NH - Z - NH - R^2 \qquad (I)$$

verwendet, worin Z eine gegebenenfalls substituierte nicht-aromatische Kohlenwasserstoffgruppe oder eine polymeren Rest darstellt,

$R^1$ und $R^2$ gleich oder verschieden sind und jeweils Wasserstoff, eine gegebenenfalls substituierte aliphatische, ungesättigte oder/und aromatische Kohlenwasserstoffgruppe oder polymeren Rest darstellen, oder/und

(b) ein primäres Amin der allgemeinen Formel (II)

$$H_2N - R^3 \qquad (II)$$

verwendet, worin $R^3$ Wasserstoff, eine gegebenenfalls substituierte aliphatische, ungesättigte oder/und aromatische Kohlenwasserstoffgruppe, eine Alkoxygruppe oder einen polymeren Rest darstellt.

Gemäß Variante (a) dieses Verfahrens wird ein Triazen-Polymer mit der Verknüpfungseinheit

$$\left[ N = N - A - N = N - \underset{\displaystyle |}{\overset{R^1}{N}} - Z - \overset{R^2}{N} \right] \qquad (IV)$$

worin A der Rest einer bifunktionellen aromatischen oder heteroaromatischen Aminverbindung nach Diazotierung und nachfolgender Umsetzung der beiden Aminogruppen ist und $R^1$, $R^2$ und Z wie zuvor definiert sind.

Das Symbol Z in den Formeln (I) und (IV) bedeutet eine gegebenenfalls substituierte nicht-aromatische Kohlenwasserstoffgruppe oder eine polymeren Rest. Vorzugsweise bedeutet Z eine gegebenenfalls mit Ether- oder Alkylaminobrücken substituierte $C_1$-$C_8$-Kohlenwasserstoffgruppe, beispielsweise eine $(CH_2)_2$- oder eine $(CH_2)_6$-Gruppe.

Die Symbole $R^1$ und $R^2$ in den Formeln (I) und (IV) können gleich und verschieden sein und bedeuten jeweils Wasserstoff, eine gegebenenfalls substituierte, aliphatische, ungesättigte oder/und aromatische Kohlenwasserstoffgruppe oder einen polymeren Rest. Wenn $R^1$ und $R^2$ Wasserstoff sind, handelt es sich bei den entstehenden Polymeren um Arylmonoalkyltriazene. Wenn $R^1$ und $R^2$ Alkylgruppen sind, handelt es sich bei den entstehenden Polymeren um Aryldialkyltriazene und wenn $R^1$ und $R^2$ aromatische oder heteroaromatische Reste (z.B. Phenyl, substituiertes Phenyl, Pyridin, Triazol etc. sind, handelt es sich bei den entstehenden Polymeren um Bisarylalkyltriazene. Vorzugsweise sind $R^1$ und $R^2$ jeweils Wasserstoff oder eine $C_1$-$C_4$-Alkylgruppe. In diesem Zusammenhang ist anzumerken, daß in der vorliegenden Beschreibung die Bezeichnung "Aryl" auch O-, S- oder/und N-heteroaromatische Verbindungen umfaßt. Weiterhin soll klargestellt werden, daß die in den Formeln (III) und (VI) wiedergegebenen Darstellungen von Benzolringen auch andere aromatische Ringsysteme, insbesondere heteroaromatische Ringe, bedeuten können.

Bei Variante (b) des oben beschriebenen Verfahrens entstehen Pentazadien-Polymere mit der Verknüpfungseinheit

$$\left[ A - N = N - \underset{R^3}{\underset{|}{N}} - N = N \right] \qquad (V)$$

worin A der Rest einer bifunktionellen aromatischen oder heteroaromatischen Aminoverbindung nach Diazotierung und nachfolgender Umsestzung der beiden Aminogruppen ist und $R^3$ wie zuvor mit Formel (II) definiert ist.

Wenn $R^3$ Wasserstoff ist, handelt es sich bei dem primären Amin der Formel (II) um Ammoniak. Das bei Reaktion von Ammoniak mit einer bifunktionellen aromatischen oder heteroaromatischen Aminverbindung entstehende Pentazadien ist ein unsubstituiertes Pentazadien. Andererseits kann $R^3$ auch eine gegebenenfalls substituierte aliphatische oder ungesättigte Kohlenwasserstoffgruppe sein. In diesem Falle ist das entstehende Polymer ein $N_3$-Alkyl- oder $N_3$-Alkenylpentazadien. Geeignete Substituenten der Alkyl- oder Alkenylgruppe sind beispielsweise Aryl, Heteroaryl, O-Alkyl, Carboxylfunktionen, Halogen, CN, Thioether, Dialkylaminogruppen und Sulfonsäuregruppen.

Weiterhin kann $R^3$ eine gegebenenfalls substituierte aromatische Kohlenwasserstoffgruppe sein. Wenn $R^3$ ein aromatischer Rest ist (d.h. die Verbindung $H_2N$-$R^3$ ist ein Anilinderivat), handelt es sich bei dem entstehenden Polymer um ein $N_3$-Arylpentazadien. Bei derartigen Anilinderivaten kann $R^3$ ein unsubstituierter Aryl- oder Heteroarylrest oder ein substituierter Aryl- oder Heteroarylrest sein. Beispiele für geeignete Substituenten sind $C_1$-$C_4$-Alkyl, $C_1$-$C_4$-Alkoxy, CN, Dialkylamino, Thioether, Aryloxy, Halogen, N=N-Aryl, Sulfonsäure und Carbonsäuregruppen.

Vorzugsweise ist $R^3$ eine gegebenenfalls substituierte $C_1$-$C_8$-Alkylgruppe, beispielsweise Ethyl-, Butyl- oder eine

Ethyl- sulfonsäuregruppe.

Das erfindungsgemäße Verfahren zur Herstellung von Triazen- oder Pentazadienpolymeren erfolgt vorzugsweise dadurch, daß die bifunktionelle aromatische oder heteroaromatische Aminverbindung durch Zugabe einer Nitritionen-haltigen Lösung bei einer Temperatur von -10°C bis +25°C in Gegenwart einer nicht-oxidierenden Säure zu einem entsprechenden Bis-Diazoniumsalz diazotiert wird.

Das Bis-Diazoniumsalz kann sowohl als frisch hergestellte Lösung oder auch als Lösung oder Suspension eines isolierten Diazoniumsalzes mit der Aminogruppen-haltigen Verbindung in einer Polykondensationsreaktion umgesetzt werden. Die Reaktion des Bis-Diazoniumsalzes und der Aminogruppen-haltigen Verbindung kann in wäßriger Lösung, vorzugsweise bei ca. 0°C in einem alkalischen pH-Bereich erfolgen. Andererseits kann die Reaktion auch als Grenzflächenpolykondensation durchgeführt werden. Dazu wird die Aminogruppen-haltige Verbindung in einem inerten, mit Wasser nicht mischbaren organischen Lösungsmittel (z.B. n-Hexan) gelöst. Anschließend wird diese Lösung in destilliertem Wasser dispergiert, welches durch Zusatz einer Base (z.B. NaOH oder $Na_2CO_3$) auf einen alkalischen pH-Bereich gebracht worden ist. Nach Zugabe einer Lösung des Bis-Diazoniumsalzes entsteht das Polymer an der Grenzfläche zwischen der wäßrigen und organischen Phase.

In einer bevorzugten Ausführungsform des erfindungsgemäßen Verfahrens verwendet man als bifunktionelle Aminoverbindung eine Bis(aminoaryl)verbindung. Vorzugsweise verwendet man eine Bis(aminoaryl)verbindung der allgemeinen Formel (III)

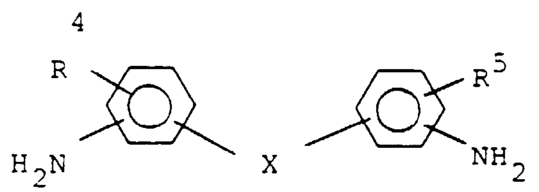

(III)

worin X eine chemische Bindung, O, S, S-S, SO, $SO_2$, CO, CO-NH, CS, N=N, NH, N(Alkyl), Y, COO, $SO_2$-NH, NH-Y-NH, NH-CO-NH, NH-$SO_2$-NH oder eine gesättigte oder ungesättigte Kohlenwasserstoffgruppe bedeutet,
$R^4$ und $R^5$ gleich oder verschieden sind, einen oder mehrere Substituenten am aromatischen Ring darstellen und jeweils H, $C_{1-4}$-Alkyl, $C_{1-4}$-Alkoxy, Y, CN, $N(Alkyl)_2$, Halogen, N=N-Y, Thioether, -OY, $SO_3H$, $CO_2H$ oder deren Salze bedeuten und Y eine gegebenenfalls substituierte aromatische oder nicht-aromatische cyclische Kohlenwasserstoffgruppe bedeutet. Das Symbol X in der allgemeinen Formel (III) bedeutet vorzugsweise eine chemische Bindung, O, CO-NH, NH oder eine $C_1$-$C_6$-Kohlenwasserstoffgruppe (z.B. $CH_2$, $(CH_2)_2$, CH=CH etc.).

Die Symbole $R^4$ und $R^5$ in der allgemeinen Formel (III) bedeuten vorzugsweise Wasserstoff, $C_1$-$C_4$ Alkyl (z.B. $CH_3$, $C_2H_5$) oder $C_1$-$C_4$-Alkoxy (z.B. $OCH_3$ , $OC_2H_5$).

Andererseits kann man als bifunktionelle Aminoverbindung auch eine mono-aromatische oder mono-heteroaromatische Verbindung verwenden. Beispiele für mono-aromatische Verbindungen sind etwa Phenylendiamine und am Benzolring substituierte Phenylendiamine. Beispiele für mono-heteroaromatische Verbindungen sind etwa N-heteroaromatische Verbindungen mit einem oder mehreren N-Atomen im aromatischen Ring, z.B. 3,5-Diamino-1,2,4-triazol.

Die Symbole Z, $R^1$, $R^2$ und $R^3$ in den Verbindungen der allgemeinen Formeln (I) und (II) können auch einen polymeren Rest darstellen. Dieser polymere Rest stammt vorzugsweise aus einem aminofunktionalen Polymer, ausgewählt aus der Gruppe, umfassend Polyethylene, Poly(allyl)amine, Polyether, Polyethylenimine, Polysaccharide oder Polypeptide. Besonders bevorzugt stammt der polymere Rest aus einem Polyether, insbesondere aus einem aminoterminalen Polyethylen-, Polypropylen- oder Poly(ethylenpropylen)oxid.

In noch einer weiteren Ausführungsform des erfindungsgemäßen Verfahrens kann man Triazen- oder/und Pentazadien-Polymere, die sich zur erfindungsgemäßen Verwendung als Photoresiste eignen, dadurch herstellen, daß man eine monofunktionelle aromatische oder heteroaromatische Aminoverbindung durch Diazotierung zu einem entsprechenden Mono-Diazoniumsalz umsetzt und dieses anschließend mit einem aminofunktionellen Polymer in einer Kondensationsreaktion zur Erzeugung eines Triazen- oder/und Pentazadien-Polymers umsetzt.

Das aminofunktionelle Polymer ist vorzugsweise aus der Gruppe, umfassend aminofunktionelle Polyethylene, Poly (allyl)-amine, Polyether, Polyethylenimine, Polysaccharide oder Polypeptide ausgewählt. Besonders bevorzugt ist das aminofunktionelle Polymer ein aminoterminales Polyethylen-, Polypropylen- oder Poly(ethylenpropylen)oxid. Auf diese Weise lassen sich z.B. aus (mit freien Aminogruppen) wasserlöslichen Polymeren durch Umsetzung mit Diazoniumsalzen Polymere mit Triazen- oder/und Pentazadiengruppierungen herstellen, deren Wasserlöslichkeit erheblich geringer als die des Ausgangspolymers ist. Die durch Belichtung erfolgende Spaltung der Triazen- oder/und Pentazadien-Gruppierungen erzeugt wiederum das ursprüngliche wasserlösliche Polymer, so daß bei einer Verwendung als Schutzschicht zur Abdeckung biochemischer Reagenzien das darunter befindliche Reagenz in Lösung gehen kann.

Wenn man bei dieser Verfahrensvariante ein Polymer mit sekundären Aminogruppen verwendet, so erhält man als Reaktionsprodukt ein Triazen-Polymer. Verwendet man dagegen ein aminofunktionelles Polymer mit primären Aminogruppen und setzt man das Diazoniumsalz in zweifachem oder höherem Überschuß bezüglich der primären Aminogruppen des Polymers ein, so erhält man als Reaktionsprodukt ein Polymer, das überwiegend Pentazadien-Funktionen aufweist. Entsprechend sind auch Mischpolymere herstellbar, die sowohl Triazen- als auch Pentazadien-Funktionen besitzen.

Die Diazotierung der monofunktionellen aromatischen oder heteroaromatischen Aminoverbindung erfolgt vorzugsweise durch Zugabe einer Nitritionen-haltigen Lösung bei einer Temperatur von -10°C bis +10°C in Gegenwart einer nicht-oxidierenden Säure, z.B. HCl. Als monofunktionelle aromatische oder heteroaromatische Aminverbindung kann man vorzugsweise ein Anilinderivat der allgemeinen Formel VI verwenden

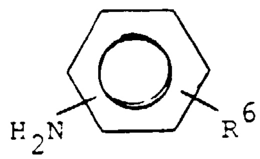

(VI)

worin $R^6$ einen oder mehrere Substituenten am aromatischen Ring darstellt und jeweils Wasserstoff, $C_{1-4}$-Alkyl, $C_{1-4}$-Alkoxy, -Y, -CN, $N(Alkyl)_2$, Halogen, N=N-Y, Thioether, -OY, $-SO_3H$, $-CO_2H$ oder deren Salze bedeuten kann und Y eine gegebenenfalls substituierte aromatische oder nicht-aromatische cyclische Kohlenwasserstoffgruppe bedeutet.

Ein bevorzugtes Beispiel eines Anilinderivats ist 3,4,5(Trimethoxy)anilin.

Ein weiterer Gegenstand der vorliegenden Erfindung sind Polymere mit Triazen- oder/und Pentazadien-Funktionen, die durch Reaktion von aminofunktionellen Polymeren mit Monodiazoniumsalzen erhältlich sind.

Die Erfindung soll weiter durch die folgenden Beispiele in Verbindung mit den Abbildungen 1 bis 4 verdeutlicht werden.

- Abb. 1 zeigt die Photolysekinetik eines Triazen-Polymers und seines entsprechenden Monomers.
- Abb. 2 zeigt die Photolysekinetik zweier Pentazadien-Polymere im Vergleich zu einem monomeren Pentazadien und einem monomeren Triazen.
- Abb. 3 zeigt die Photolysekinetik zweier Pentazadien-Polymere und einer monomeren Pentazadien-Verbindung bei Bestrahlung mit Weißlicht.
- Abb. 4 zeigt die Photolysekinetik eines Bis-Pentazadien-Polyethylenglycols.

**Beispiel 1**

0,01 mol (2,00 g) Bis-(4-aminophenyl)ether werden bei einer Temperatur von -10 bis 0°C in 25 ml verdünnter wäßriger Mineralsäure (z.B. 10 %ige HCl) gelöst. Durch Zugabe einer auf 0°C abgekühlten, wäßrigen Lösung von 0,02 mol (1,38 g) Natriumnitrit erhält man das entsprechende Bis-Diazoniumsalz, wobei die Reaktionszeit zur Vervollständigung der Diazotierungsreaktion von der verwendeten Bis-(aminophenyl)-Verbindung abhängt.

Die so erhaltene Bis-Diazoniumsalzlösung wird durch Zugabe von 175 ml einer auf 0°C gekühlten wäßrigen Lösung einer Base (8,0 g Natriumcarbonat) in einen alkalischen pH-Bereich gebracht und unter heftigem Rühren mit einer auf 0°C gekühlten wäßrigen Lösung von 0,01 mol 1,6-Bis(methylamino)hexan in 100 ml n-Hexan versetzt. Die Reaktionsmischung wird noch 1 Stunde bei 0°C gerührt und anschließend das entstandene Triazenpolykondensat TP1 abfiltriert, mit destilliertem Wasser gewaschen und getrocknet.

Auf analoge Weise wurden nach der obigen Synthesebeschreibung die in Tabelle 1 aufgelisteten Triazen-Polymere TP1 - TP13 hergestellt:

Tabelle 1

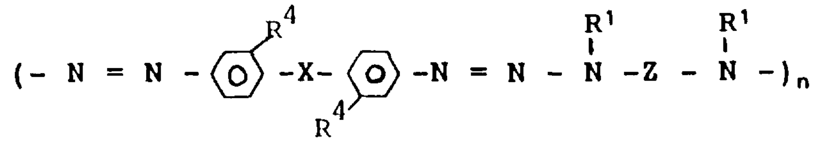

| Polymer | Edukte | X | $R^4$ | $R^1$ | Z |
| --- | --- | --- | --- | --- | --- |
| TP1 | 1,6-Bis(methylamino)hexan<br>Bis(4-aminophenyl)ether | O | H | $CH_3$ | $(CH_2)_6$ |
| TP2 | 1,2-Bis(methylamino)ethan<br>Bis(4-aminophenyl)ether | O | H | $CH_3$ | $(CH_2)_2$ |
| TP3 | 2,3,5,6-Tetramethyl-p-phenylendiamin<br>Bis(4-aminophenyl)ether | O | H | H | 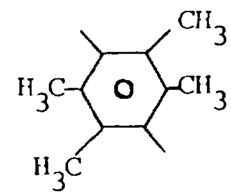 |
| TP4 | 1,2-Bis(methylamino)ethan<br>4,4'-Diaminostilben-2,2'-disulfonsäure | CH=CH | $SO^-_3Na^+$ | $CH_3$ | $(CH_2)_2$ |
| TP5 | 1,6-Bis(methylamino)hexan<br>4,4'-Diaminostilben-2,2-disulfonsäure | CH=CH | $SO^-_3Na^+$ | $CH_3$ | $(CH_2)_6$ |
| TP6 | 2,4,6-Trimethyl-m-phenylendiamin<br>4,4'-Diaminostilben-2,2'-disulfonsäure | CH=CH | $SO^-_3Na^+$ | H | 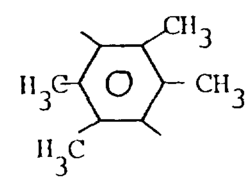 |

| | | | | | |
|---|---|---|---|---|---|
| TP7 | 1,3-Bis(methylamino)propan<br>Bis(4-aminophenyl)ether | O | H | $CH_3$ | $(CH_2)_3$ |
| TP8 | 1,4-Bis(methylamino)-2-buten<br>Bis(4-aminophenyl)ether | O | H | $CH_3$ | $-CH_2-CH=CH-CH_2-$ |
| TP9 | 1,8-Bis(methylamino)-3,6-dioxaoctan<br>Bis(4-aminophenyl)ether | O | H | $CH_3$ | $-(CH_2)_2-O-(CH_2)_2-O-(CH_2)_2-$ |
| TP10 | 1,6-Bis(methylamino)hexan<br>4,4'-Diaminostilben | CH=CH | H | $CH_3$ | $(CH_2)_6$ |
| TP11 | 1,6-Bis(methylamino)hexan<br>4,4'-Diaminobenzophenon | C=O | H | $CH_3$ | $(CH_2)_6$ |
| TP12 | 1,6-Bis(methylamino)hexan<br>Bis(4-aminophenyl)sulfon | $SO_2$ | H | $CH_3$ | $(CH_2)_6$ |
| TP13 | 1,6-Bis(methylamino)hexan<br>(4,4'-Diaminodiphenyl)sulfid | S | H | $CH_3$ | $(CH_2)_6$ |

**Beispiel 2**

**Synthese von Pentazadien-Polymeren durch Polykondensation**

0,01 mol (2,00 g) Bis-(4-aminophenyl)ether wurden bei einer Temperatur von -10 bis 0°C in 25 ml verdünnter wäßriger Mineralsäure (z.B. 10 %ige HCl) gelöst. Durch Zugabe einer auf 0°C abgekühlten wäßrigen Lösung von 0,02 mol (1,38 g) Natriumnitrit erhält man das entsprechende Bis-Diazoniumsalz, wobei die Reaktionszeit bis zur Vervollständigung der Diazotierungsreaktion von der verwendeten Bis-(aminophenyl)-Verbindung abhängt.

Die so erhaltene Bis-Diazoniumsalzlösung wird durch Zugabe einer auf 0°C gekühlten wäßrigen Lösung einer Base (z.B. 8,0 g Natriumcarbonat) auf einen alkalischen pH gebracht und unter heftigem Rühren mit einer auf 0°C gekühlten wäßrigen Lösung von 0,01 mol Butylamin versetzt. Die Reaktionsmischung wird noch 1 Stunde bei 0°C gerührt und anschließend wird das entstandene Pentazadien-Polykondensat PP1 abfiltriert, mit destilliertem Wasser gewaschen und getrocknet.

Auf analoge Weise wurden nach obiger Synthesebeschreibung die in Tabelle 2 aufgelisteten Pentazadien-Polymere PP2 bis PP7 hergestellt:

Tabelle 2

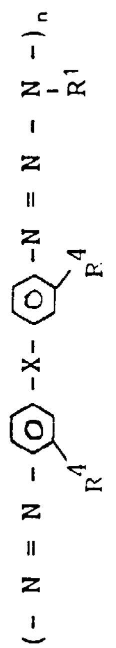

| Polymer | Edukte | X | $R^1$ | $R^4$ |
|---|---|---|---|---|
| PP1 | Butylamin<br>Bis(4-aminophenyl)ether | O | Butyl | H |
| PP2 | Butylamin<br>3,3'-Dimethoxy-benzidin | - | Butyl | OMe |
| PP3 | Ethylamin<br>Bis(4-aminophenyl)ether | O | Ethyl | H |
| PP4 | Taurin<br>Bis(4-aminophenyl)ether | O | $CH_2-CH_2-SO_3^-Na^+$ | H |
| PP5 | Ethylamin<br>4,4'-Diaminobenzanilid | CO-NH | Ethyl | H |
| PP6 | Ethylamin<br>4,4'-Diaminostilben | CH=CH | Ethyl | H |
| PP7 | Ethylamin<br>Bis(4-aminophenyl)amin | NH | Ethyl | H |

<u>Beispiel 3</u>

**Photolyse von Triazen- und Pentazadien-Polymeren in Lösung**

**3.1 Triazen und Triazen-Polymere**

Eine Lösung der Testsubstanz in THF mit ca. 5 % Wasser in einer Quarzküvette (d = 10 mm) wurde in 50 cm

Abstand ohne abbildende optische Elemente mit einer Hg-Xe-Hochdrucklampe (100 W) belichtet. Die Photolyse der Triazen-Funktionen läßt sich an der Abnahme ihrer charakteristischen Absorptionsbande bei ca. 320 nm verfolgen, die zu Beginn der Belichtung ein Absorptionsmaximum von ca. E=2 (entsprechend 100 %) aufwies.

Abb. 1 zeigt die Photolysekinetik eines Triazen-Polymers und seiner entsprechenden monomeren Modellverbindung zum Vergleich. Der Rückstand aus der Belichtung des Polymers, der nach Eintrocknen (Verblasen) des Lösungsmittels erhalten wird, ist vollständig wasserlöslich. Dies zeigt, daß wasserlösliche Bruchstücke des wasserunlöslichen Polymers entstehen.

Durch Eintrocknen eines Tropfens der THF-Lösung des Triazen-Polymers auf einem Glasplättchen erhält man einen sehr gleichmäßigen und klaren, leicht gelblichen Film von einigen µm Dicke.

### 3.2 Pentazadien und Pentazadien-Polymere

Die Durchführung des Versuchs erfolgte wie in Beispiel 3.1 beschrieben. Abb. 2 zeigt den Verlauf der Photolysekinetik zweier dort gezeigter Pentazadienpolymere im Vergleich zu einem monomeren Pentazadien und einem monomeren Triazen. Der Rückstand aus der Belichtung der Polymere ist wieder gut wasserlöslich. Ebenso findet man eine gute Filmbildung.

### 3.3 Pentazadien und Pentazadien-Polymere bei Weißlicht-Belichtung

Die Durchführung des Versuchs erfolgte wie in Beispiel 1 und Beispiel 2. Es wurde jedoch statt mit der Hg-Xe-Hochdrucklampe in einem kommerziellen Fluorimeter mit wesentlich schwächerer Intensität belichtet, d.h. es fallen ca. 300 mW annähernd gleichverteilt von 250 bis 750 nm auf die Probe, d.h. ca. 30 bis 40 Mw im Bereich der Absorptionsbande bei 380 nm. Abb. 3 zeigt den Verlauf der Photolysekinetik zweier Pentazadien-Polymere und einer monomeren Pentazadien-Verbindung (Verbindungen entsprechend Beispiel 3.2).

### 3.4 Bis-Pentazadien-Polyethylenglycol

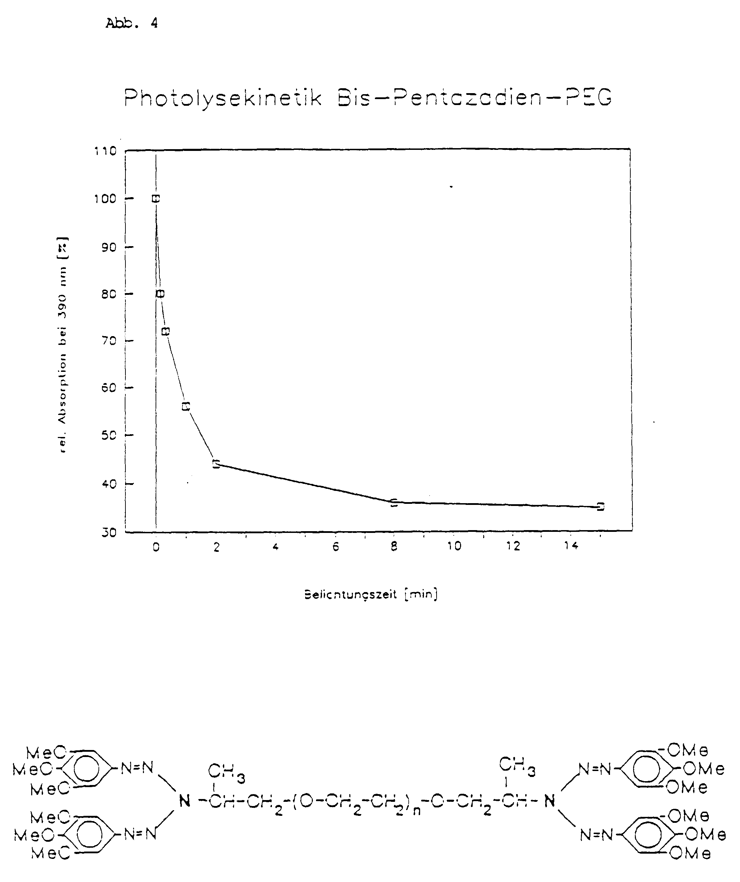

Die Durchführung des Versuchs erfolgte wie unter 3.3 beschrieben. Abb. 4 zeigt die Photolysekinetik eines Bis-Pentazadien-Polyethylenglycols.

Wie in den vorigen Experimenten ist der Rückstand aus der Belichtung des Polymers wieder gut wasserlöslich. Ebenso wird eine gute Filmbildung beobachtet.

Dieses Bis-Pentazadien-Polyethylenglycol wurde aus einem amino-terminierten Polyethylenglycol mit einer Molmasse von ca. 1900 hergestellt.

Die Diazotierung von 3,4,5-(Trimethoxy)anilin erfolgte entsprechend der Vorschrift von Beispiel 1. Die so erhaltene Bis-Diazoniumsalzlösung wurde zu einer auf 0°C gekühlten wäßrigen Lösung von 0,0025 mol des aminoterminierten Polyethylenglycols (4,75 g) und 8,0 g $Na_2CO_3$ gegeben. Das Produkt wurde nach 1-stündigem Rühren bei 0°C als beige-oranger Feststoff abgeschieden. Es kann anschließend abfiltriert und getrocknet werden.

## Patentansprüche

1. Verwendung von Triazen- oder/und Pentazadien-Polymeren als Photoresiste.

2. Verwendung nach Anspruch 1 als photolabile Schutzschichten zur Abdeckung biochemischer Reagenzien.

3. Verwendung nach Anspruch 2 in einem Verfahren zur Bestimmung eines Analyten in einer Probenflüssigkeit durch eine in mehreren zeitlich voneinander getrennten Stufen ablaufenden Reaktion.

4. Verfahren zur Herstellung von Triazen- oder/und Pentazadien-Polymeren,
   **dadurch gekennzeichnet**,
   daß man eine bifunktionelle aromatische oder heteroaromatische Aminoverbindung durch Diazotierung zu einem entsprechenden Bis-Diazoniumsalz umsetzt und dieses anschließend mit einer Aminogruppen-haltigen Verbindung in einer Polykondensationsreaktion zur Erzeugung eines Polymers umsetzt, wobei man als Aminogruppen-haltige Verbindung

   (a) ein bifunktionelles primäres oder sekundäres Amin der allgemeinen Formel (I)

$$R^1 - NH - Z - NH - R^2 \quad (I)$$

verwendet, worin Z eine gegebenenfalls substituierte nicht-aromatische Kohlenwasserstoffgruppe oder eine polymeren Rest darstellt,
$R^1$ und $R^2$ gleich oder verschieden sind und jeweils Wasserstoff, eine gegebenenfalls substituierte aliphatische, ungesättigte oder/und aromatische Kohlenwasserstoffgruppe oder einen polymeren Rest darstellen, oder/und
(b) ein primäres Amin der allgemeinen Formel (II)

$$H_2N - R^3 \quad (II)$$

verwendet, worin $R^3$ Wasserstoff, eine gegebenenfalls substituierte aliphatische, ungesättigte oder/und aromatische Kohlenwasserstoffgruppe oder einen polymeren Rest darstellt.

**5.** Verfahren nach Anspruch 4,
**dadurch gekennzeichnet**,
daß der polymere Rest aus einem aminofunktionellen Polymer, ausgewählt aus der Gruppe, umfassend aminofunktionelle Polyethylene, Poly(allyl)amine, Polyether, Polyethylenimine, Polysaccharide oder Polypeptide, stammt.

**6.** Verfahren nach Anspruch 4 oder 5,
**dadurch gekennzeichnet**,
daß die Diazotierung durch Zugabe einer Nitritionen-haltigen Lösung bei einer Temperatur von -10°C bis +25°C in Gegenwart einer nicht-oxidierenden Säure erfolgt.

**7.** Verfahren nach einem der Ansprüche 4 bis 6,
**dadurch gekennzeichnet**,
daß man als bifunktionelle aromatische oder heteroaromatische Aminoverbindung eine Bis(aminoaryl)-Verbindung verwendet.

**8.** Verfahren nach Anspruch 7,
**dadurch gekennzeichnet**,
daß man als Bis(aminoaryl)-Verbindung eine Substanz der allgemeinen Formel (III) verwendet,

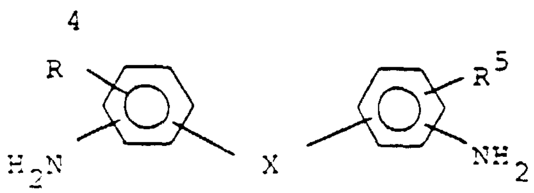

(III)

worin X eine chemische Bindung, O, S, S-S, SO, $SO_2$, CO, CO-NH, CS, N=N, NH, N(Alkyl), Y, COO, $SO_2$-NH, NH-Y-NH, NH-CO-NH, NH-$SO_2$-NH oder eine gesättigte oder ungesättigte Kohlenwasserstoffgruppe bedeutet,
$R^4$ und $R^5$ gleich oder verschieden sind, einen oder mehrere Substituienten am aromatischen Ring darstellen und jeweils H, $C_{1-4}$-Alkyl, $C_{1-4}$-Alkoxy, Y, CN, $N(Alkyl)_2$, Halogen, N=N-Y, Thioether, -OY, $SO_3H$, $CO_2H$ oder deren Salze bedeuten und Y eine gegebenenfalls substituierte aromatische oder nicht-aromatische cyclische Kohlenwasserstoffgruppe bedeutet.

**9.** Triazen-Polymer mit der Verknüpfungseinheit

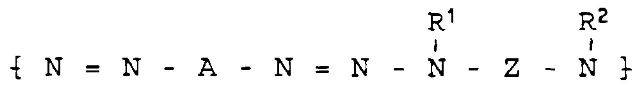 (IV)

worin A der Rest einer bifunktionellen aromatischen oder heteroaromatischen Aminoverbindung nach Diazotierung und nachfolgender Umsetzung der beiden Aminogruppen ist und $R^1$, $R^2$ und Z wie in Anspruch 4 definiert sind.

**10.** Pentazadien-Polymer mit der Verknüpfungseinheit

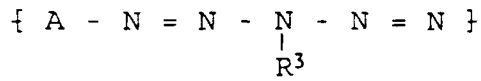 (V)

worin A der Rest einer bifunktionellen aromatischen oder heteroaromatischen Aminoverbindung nach Diazotierung und nachfolgender Umsetzung der beiden Aminogruppen ist und $R^3$ wie in Anspruch 4 definiert ist.

**11.** Verfahren zur Herstellung von Triazen- oder/und Pentazadien-Polymeren,
**dadurch gekennzeichnet**,
daß man eine monofunktionelle aromatische oder heteroaromatische Aminoverbindung durch Diazotierung zu einem entsprechenden Mono-Diazoniumsalz umsetzt und dieses anschließend mit einem aminofunktionellen Polymer in einer Kondensationsreaktion zur Erzeugung eines Triazen- oder/und Pentazadien-Polymers umsetzt.

**12.** Verfahren nach Anspruch 11,
**dadurch gekennzeichnet**,
daß man ein aminofunktionelles Polymer, ausgewählt aus der Gruppe, umfassend aminofunktionelle Polyethylene, Poly(allyl)amine, Polyether, Polyethylenimine, Polysaccharide oder Polypeptide, verwendet.

**13.** Verfahren nach Anspruch 12,
**dadurch gekennzeichnet**,
daß die Diazotierung durch Zugabe einer Nitritionen-haltigen Lösung bei einer Temperatur von -10°C bis +25°C in Gegenwart einer nicht-oxidierenden Säure erfolgt.

**14.** Verfahren nach einem der Ansprüche 11 bis 13,
**dadurch gekennzeichnet**,
daß man als monofunktionelle aromatische oder heteroaromatische Aminoverbindung ein Anilinderivat der allgemeinen Formel (VI) verwendet,

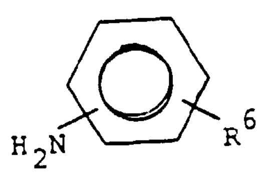 (VI)

worin $R^6$ einen oder mehrere Substituenten am aromatischen Ring darstellt und jeweils Wasserstoff, $C_{1-4}$-Alkyl, $C_{1-4}$-Alkoxy, -Y, -CN, $N(Alkyl)_2$, Halogen, N=N-Y, Thioether, -OY, $-SO_3H$, $-CO_2H$ oder deren Salze bedeuten kann und
Y eine gegebenenfalls substituierte aromatische oder nicht-aromatische cyclische Kohlenwasserstoffgruppe bedeutet.

**15.** Triazen- oder/und Pentazadien-Polymer, erhältlich durch ein Verfahren nach einem der Ansprüche 11 bis 14.

## Claims

1. Use of triazene or/and pentazadiene polymers as photoresists.

2. Use as claimed in claim 1 as photolabile protective layers for covering biochemical reagents.

3. Use as claimed in claim 2 in a method for the determination of an analyte in a sample liquid by a reaction which proceeds in several steps separated from one another in time.

4. Process for the production of triazene or/and pentazadiene polymers,
**wherein**
a bifunctional aromatic or heteroaromatic amino compound is converted by diazotization into a corresponding bis-diazonium salt and this is subsequently reacted with a compound containing amino groups in a polycondensation reaction to produce a polymer, wherein

(a) a bifunctional primary or secondary amine of the general formula (I)

$$R^1 - NH - Z - NH - R^2 \quad (I)$$

is used as the compound containing amino groups, in which Z represents a non-aromatic hydrocarbon group which is substituted if desired or a polymeric residue,
$R^1$ and $R^2$ are the same or different and each represents hydrogen, an aliphatic, unsaturated or/and aromatic hydrocarbon group which is substituted if desired or a polymeric residue, or/and
(b) a primary amine of the general formula (II)

$$H_2N - R^3 \quad (II)$$

is used as the compound containing amino groups, in which $R^3$ represents hydrogen, an aliphatic, unsaturated or/and aromatic hydrocarbon group which is substituted if desired or a polymeric residue.

5. Process as claimed in claim 4,
**wherein**
the polymeric residue is derived from an amino-functional polymer selected from the group comprising amino-functional polyethylenes, poly(allyl)amines, polyethers, polyethylenimines, polysaccharides or polypeptides.

6. Process as claimed in claim 4 to 5,
**wherein**
the diazotization is carried out by adding a solution containing nitrite ions at a temperature of -10°C to +25°C in the presence of a non-oxidizing acid.

7. Process as claimed in one of the claims 4 to 6,
**wherein**
a bis(aminoaryl) compound is used as the bifunctional aromatic or heteroaromatic amino compound.

8. Process as claimed in claim 7,
**wherein**
a substance of the general formula (III) is used as the bis(aminoaryl) compound

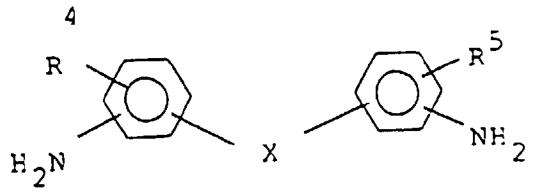 (III)

in which X denotes a chemical bond, O, S, S-S, SO, $SO_2$, CO, CO-NH, CS, N=N, NH, N(alkyl), Y, COO, $SO_2$-NH, NH-Y-NH, NH-CO-NH, NH-$SO_2$-NH or a saturated or unsaturated hydrocarbon group,
$R^4$ and $R^5$ are the same or different, represent one or several substitutents on the aromatic ring and each denotes H, $C_{1-4}$ alkyl, $C_{1-4}$ alkoxy, Y, CN, $N(alkyl)_2$, halogen, N=N-Y, thioether, -OY, $SO_3H$, $CO_2H$ or their salts and Y denotes an aromatic or non-aromatic cyclic hydrocarbon group which is substituted if desired.

**9.** Triazene polymer with the linking unit

$$[- N = N - A - N = N - \underset{}{\overset{R^1}{N}} - Z - \overset{R^2}{N} -] \qquad (IV)$$

in which A is the residue of a bifunctional aromatic or heteroaromatic amino compound after diazotization and subsequent reaction of the two amino groups and $R^1$, $R^2$ and Z are defined as in claim 4.

**10.** Pentazadiene polymer with the linking unit

$$[- A - N = N - \underset{R^3}{N} - N = N -] \qquad (V)$$

in which A is the residue of a bifunctional aromatic or heteroaromatic amino compound after diazotization and subsequent reaction of both amino groups and $R^3$ is defined as in claim 4.

**11.** Process for the production of triazene or/and pentazadiene polymers,
**wherein**
a monofunctional aromatic or heteroaromatic amino compound is converted by diazotization into a corresponding mono-diazonium salt and this is subsequently reacted with an amino-functional polymer in a condensation reaction to produce a triazene or/and pentazadiene polymer.

**12.** Process as claimed in claim 11,
**wherein**
an amino-functional polymer selected from the group comprising amino-functional polyethylenes, poly(allyl) amines, polyethers, polyethylenimines, polysaccharides or polypeptides is used.

**13.** Process as claimed in claim 12,
**wherein**
the diazotization is carried out by adding a solution containing nitrite ions at a temperature of -10°C to +25°C in the presence of a non-oxidizing acid.

**14.** Process as claimed in one of the claims 11 to 13,
**wherein**
an aniline derivative of the general formula VI is used as the monofunctional aromatic or heteroaromatic amino compound

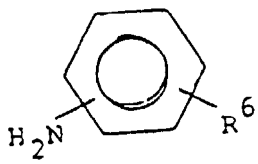

(VI)

in which $R^6$ represents one or several substituents on the aromatic ring and each of which can denote hydrogen, $C_{1-4}$ alkyl, $C_{1-4}$ alkoxy, -Y, -CN, $N(alkyl)_2$, halogen, N=N-Y, thioether, -OY, $-SO_3H$, $-CO_2H$ or their salts and Y denotes an aromatic or non-aromatic cyclic hydrocarbon group which is substituted if desired.

**15.** Triazene or/and pentazadiene polymer obtainable by a process as claimed in one of the claims 11 to 14.

**Revendications**

**1.** Utilisation de polymères de triazène et/ou de pentazadiène comme photorésists.

**2.** Utilisation selon la revendication 1 comme couches protectrices photolabiles pour le recouvrement de réactifs biochimiques.

**3.** Utilisation selon la revendication 2 dans un procédé de détermination d'un analyte dans un liquide échantillon par une réaction qui se déroule en plusieurs étapes séparées les unes des autres dans le temps.

**4.** Procédé de préparation de polymères de triazène et/ou de pentazadiène, caractérisé en ce que l'on convertit un composé aminé aromatique ou hétéroaromatique bifonctionnel par diazotation en un sel de bisdiazonium correspondant puis on fait réagir celui-ci avec un composé contenant des groupes amino dans une réaction de polycondensation pour produire un polymère, en utilisant comme composé contenant des groupes amino

(a) une amine primaire ou secondaire bifonctionnelle de formule générale (I)

$$R^1 - NH - Z - NH - R^2 \qquad (I)$$

dans laquelle Z représente un groupe hydrocarboné non aromatique éventuellement substitué ou un reste polymérique,
$R^1$ et $R^2$ sont identiques ou différents et représentent chacun l'hydrogène, un groupe hydrocarboné aliphatique, insaturé et/ou aromatique éventuellement substitué ou un reste polymérique, et/ou
(b) une amine primaire de formule générale (II)

$$H_2N - R^3 \qquad (II)$$

dans laquelle $R^3$ représente l'hydrogène, un groupe hydrocarboné aliphatique, insaturé et/ou aromatique éventuellement substitué ou un reste polymérique.

**5.** Procédé selon la revendication 4, caractérisé en ce que le reste polymérique provient d'un polymère aminofonctionnel choisi dans le groupe comportant les polyéthylènes, les poly(allyl)amines, les polyéthers, les polyéthylène-imines, les polysaccharides et les polypeptides aminofonctionnels.

**6.** Procédé selon la revendication 4 ou 5, caractérisé en ce que la diazotation a lieu par addition d'une solution contenant des ions nitrite à une température de -10°C à +25°C en présence d'un acide non oxydant.

**7.** Procédé selon l'une des revendications 4 à 6, caractérisé en ce que l'on utilise comme composé aminé aromatique ou hétéroaromatique bifonctionnel un composé bis(aminoaryle).

**8.** Procédé selon la revendication 7, caractérisé en ce que l'on utilise comme composé bis(aminoaryle) une substance de formule générale (III)

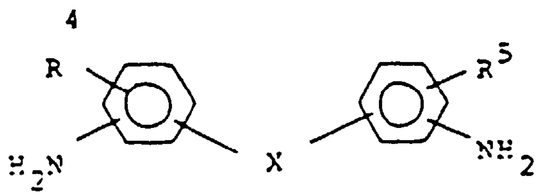

(III)

dans laquelle X représente une liaison chimique, O, S, S-S, SO, $SO_2$, CO, CO-NH, CS, N=N, NH, N(alkyle), Y, COO, $SO_2$-NH, NH-Y-NH, NH-CO-NH, NH-$SO_2$-NH ou un groupe hydrocarboné saturé ou insaturé, $R^4$ et $R^5$ sont identiques ou différents, représentent un ou plusieurs substituants sur le cycle aromatique et représentent chacun H, alkyle en $C_{1-4}$, alcoxy en $C_{1-4}$, Y, CN, $N(alkyle)_2$, halogène, N=N-Y, thioéther, -OY, $SO_3H$, $CO_2H$ ou leurs sels et Y représente un groupe hydrocarboné aromatique ou non aromatique cyclique éventuellement substitué.

**9.** Polymère de triazène ayant l'unité de liaison

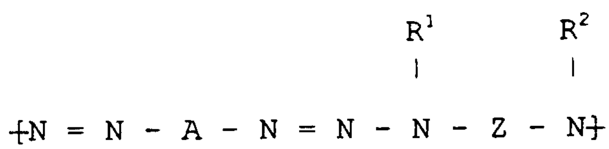

(IV)

dans laquelle A est le reste d'un composé aminé aromatique ou hétéroaromatique bifonctionnel après diazotation et réaction subséquente des deux groupes amino et $R^1$, $R^2$ et Z sont définis comme dans la revendication 4.

**10.** Polymère de pentazadiène ayant l'unité de liaison

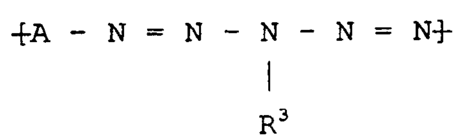

(V)

dans laquelle A est le reste d'un composé aminé aromatique ou hétéroaromatique bifonctionnel après diazotation et réaction subséquente des deux groupes amino et $R^3$ est défini comme dans la revendication 4.

**11.** Procédé de préparation de polymères de triazène et/ou de pentazadiène, caractérisé en ce que l'on convertit un composé aminé aromatique ou hétéroaromatique monofonctionnel par diazotation en un sel de monodiazonium correspondant puis on fait réagir celui-ci avec un polymère aminofonctionnel dans une réaction de condensation pour produire un polymère de triazène et/ou de pentazadiène.

**12.** Procédé selon la revendication 11, caractérisé en ce que l'on utilise un polymère aminofonctionnel choisi dans le groupe comportant les polyéthylènes, les poly(allyl)amines, les polyéthers, les polyéthylène-imines, les polysaccharides et les polypeptides aminofonctionnels.

**13.** Procédé selon la revendication 12, caractérisé en ce que la diazotation a lieu par addition d'une solution contenant des ions nitrite à une température de -10°C à +25°C en présence d'un acide non oxydant.

**14.** Procédé selon l'une des revendications 11 à 13, caractérisé en ce que l'on utilise comme composé aminé aromatique ou hétéroaromatique monofonctionnel un dérivé de l'aniline de formule générale (VI)

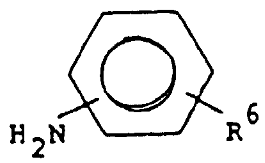

(VI)

dans laquelle $R^6$ représente un ou plusieurs substituants sur le cycle aromatique et représente dans chaque cas l'hydrogène, alkyle en $C_{1-4}$, alcoxy en $C_{1-4}$, -Y, -CN, $N(alkyle)_2$, halogène, N=N-Y, thioéther, -OY, $-SO_3H$, $-CO_2H$ ou leurs sels et
Y représente un groupe hydrocarboné aromatique ou non aromatique cyclique éventuellement substitué.

**15.** Polymère de triazène et/ou de pentazadiène qui peut être obtenu par un procédé selon l'une des revendications 11 à 14.

Abb. 1

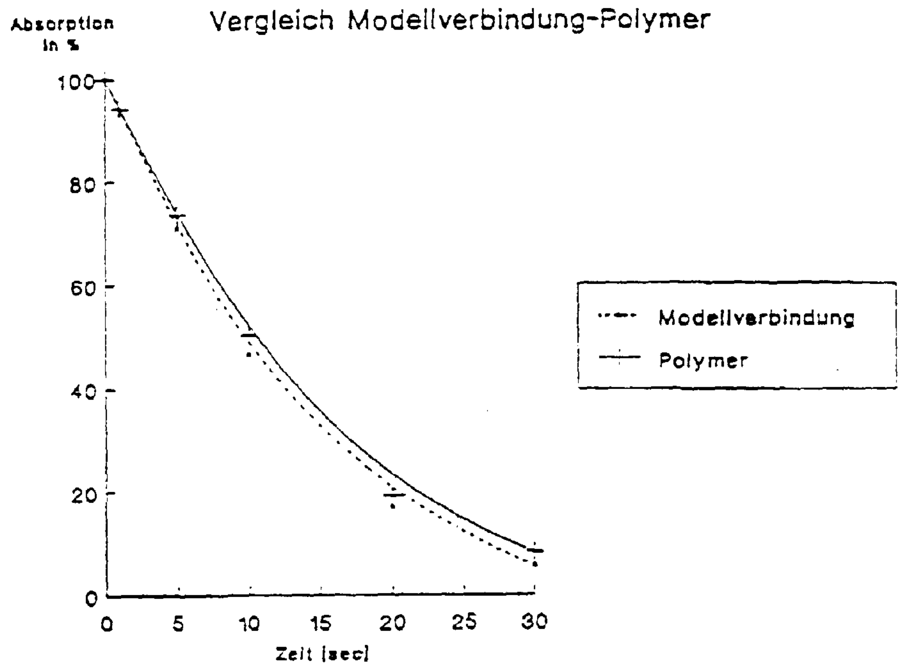


Modellverbindung:

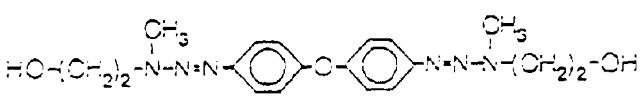

Triazenpolymer:

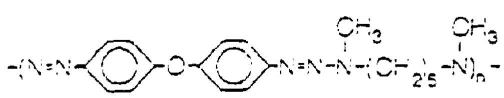

Abb. 2

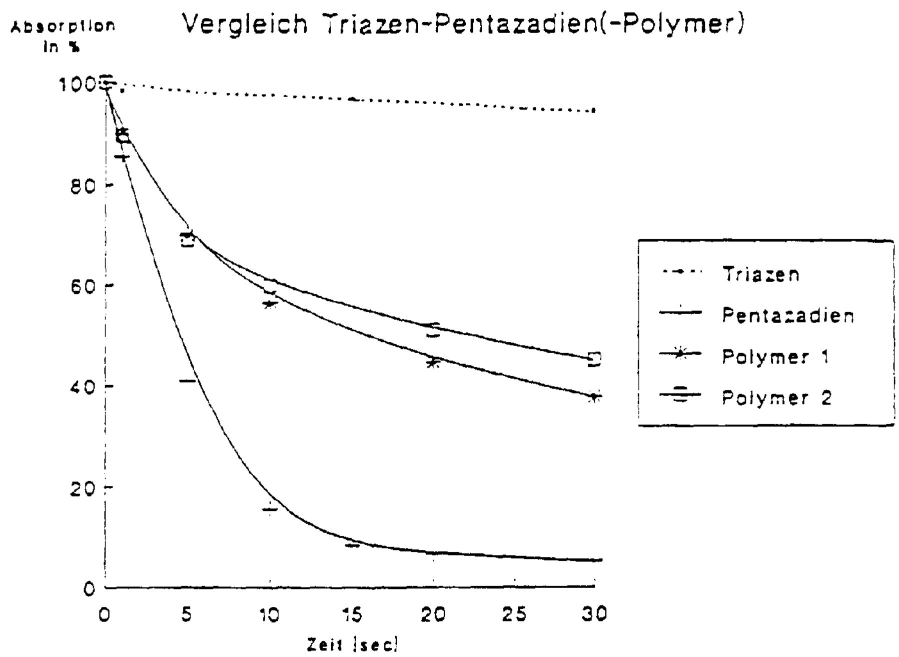


Triazen: 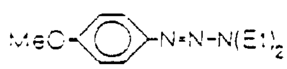

Pentazadien: 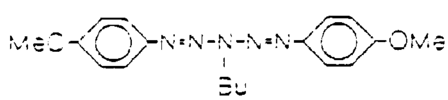

Polymer1: 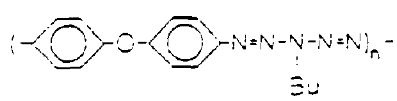

Polymer2: 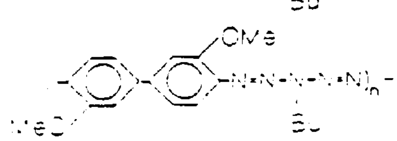

Abb. 3

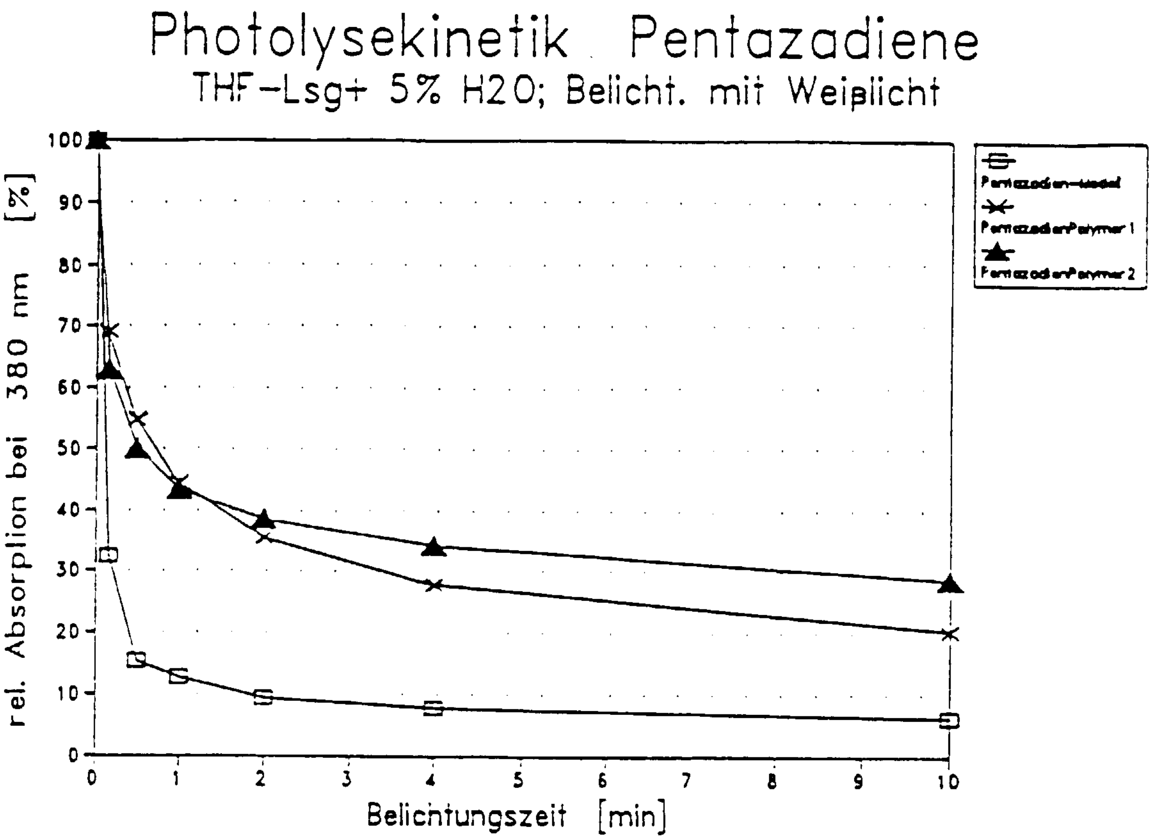
Photolysekinetik Pentazadiene
THF–Lsg+ 5% H2O; Belicht. mit Weißlicht
rel. Absorption bei 380 nm [%]
100
90
80
70
60
50
40
30
20
10
0
0
1
2
3
4
5
6
7
8
9
10
Belichtungszeit [min]
PentazadienPolymer 1
PentazadienPolymer 2

Abb. 4

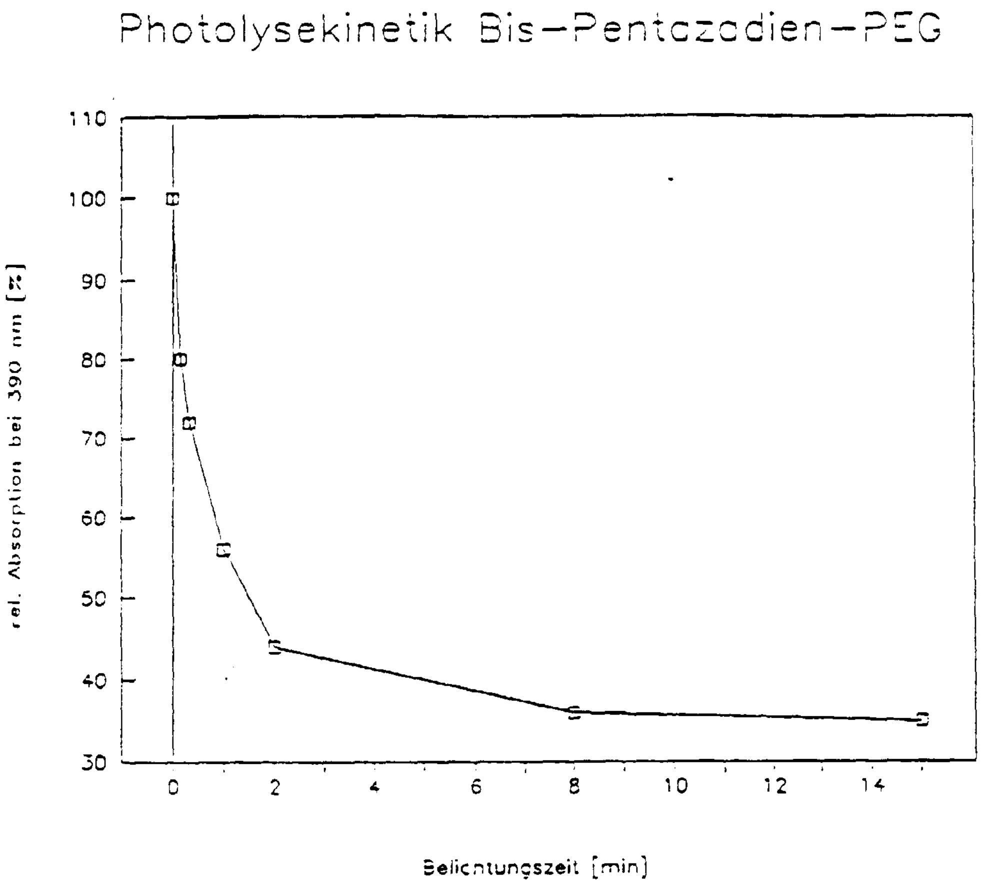
Photolysekinetik Bis-Pentazadien-PEG
rel. Absorption bei 390 nm [%]
110
100
90
80
70
60
50
40
30
0
2
4
6
8
10
12
14
Belichtungszeit [min]